Europäisches Patentamt

European Patent Office

Office européen des brevets

(11) Veröffentlichungsnummer: **0 440 929 A2**

# EUROPÄISCHE PATENTANMELDUNG

(21) Anmeldenummer: 90123920.2

(51) Int. Cl.5: **H05K 3/00**

(22) Anmeldetag: **12.12.90**

(30) Priorität: **05.02.90 DE 4003345**

(43) Veröffentlichungstag der Anmeldung:
**14.08.91 Patentblatt 91/33**

(84) Benannte Vertragsstaaten:
**AT BE CH DE DK ES FR GB GR IT LI LU NL SE**

(71) Anmelder: **Firma Carl Freudenberg
Höhnerweg 2-4
W-6940 Weinheim/Bergstrasse(DE)**

(72) Erfinder: **Kober, Horst
Berggewann 5
W-6940 Weinheim(DE)**
Erfinder: **Horch, Uwe
Illerstrasse 2
W-7070 Schwäbisch-Gmünd(DE)**

(54) **Verfahren zur Herstellung einer starre und flexible Bereiche aufweisenden Leiterplatte.**

(57) Ein Verfahren zur Herstellung einer starre und flexible Bereiche aufweisenden Leiterplatte durch Verpressen von starren und flexiblen Einzellagen und Entfernen von starren Bereichen in den flexibel gewünschten Zonen besteht darin, daß man nach dem Ausbilden der Sollbruchstellen, die den flexibel zu gestaltenden Bereich umgrenzen, eine Isolationsfolie mittels einer nicht fließenden Kleberschicht auf die starre Einzellage schaltungsseitig und nur im flexibel zu gestaltenden Bereich aufklebt, wobei die Isolationsfolie allseitig die Abmessungen des flexiblen Bereichs etwas überragt, daß man die Isolationsfolie mit einer zusätzlichen Kleberschicht auf ihrer der Einzellage abgewandten Seite versieht, daß man ein Prepreg, das gleich dick wie oder einige μm dicker ist als die Isolationsfolie einschließlich Kleberbeschichtung ist, auf diese überdeckend aufträgt, wobei man das Prepreg im flexiblen Bereich ausspart, daß man dann über das gesamte Prepreg eine durchgehende Kupferfolie auflegt, daß man den Verbund unter Druck und bei einer Temperatur, die den Kleber und das Prepreg klebend aktiviert, zu einem Laminat verpreßt, die Kleberverbindung aushärten läßt und nach der Leiterbild-Herstellung und der Konturbearbeitung zuletzt im flexiblen Bereich die Einzellage mit der Kupferbeschichtung entlang der Sollbruchstellen entfernt.

EP 0 440 929 A2

# VERFAHREN ZUR HERSTELLUNG EINER STARRE UND FLEXIBLE BEREICHE AUFWEISENDEN LEITER-PLATTE

Die Erfindung betrifft ein Verfahren zur Herstellung einer starre und flexible Bereiche aufweisenden Leiterplatte gemäß dem Oberbegriff des Anspruchs, wobei nur in den flexiblen Bereichen ein flexibler Isolationsträger vorgesehen wird.

Ein solches Verfahren wird in der DE-PS 26 57 212 beschrieben. Dabei überdecken die flexiblen Einzellagen die gesamte Leiterplatte, obwohl jene nur im flexiblen Teil benötigt werden.

Die für die flexiblen Einzellagen verwendeten Kunststoffolien sind hygroskopisch, so daß beim Löten der Schaltung durch das Verdampfen der absorbierten Feuchtigkeit Delaminationen zwischen flexibler und starrer Lage auftreten können.

Der zwischen den starren und flexiblen Einzellagen benötigte Kleber wird ganzflächig aufgetragen und ist nicht fließend, d.h. er ist auch während des Verpressens so zäh, daß er nicht in die flexiblen Bereiche fließen und dort versehentlich den flexiblen Teil mit der starren Außenlage verkleben kann. Solche Kleber benötigen zum Verpressen den Einsatz eines bekannten Druckausgleichspolsters, um trotz ihrer hohen Viskosität eine homogene Verklebung von flexibler und starrer Einzellage zu erzielen. Dieses Polster bewirkt jedoch, wenn Leiterbahnen auf der Innenseite der starren Einzellage vorhanden sind, daß diese Leiterbahnen sich in die flexible Einzellage drücken und zur Reliefbildung auf deren Kupferfolie führen. Die ätztechnische Herstellung der Leiterbahnen auf dieser Kupferfolie wird somit erschwert.

In DE-PS 36 24 718 wird beschrieben, wie eine mehrlagige starr-flexible Leiterplatte mit flexiblen Kunststoffolien nur im flexiblen Teil hergestellt wird. Aber dieses Verfahren benötigt die Herstellung starr-flexibler Vorlaminate.

Aufgabe der Erfindung ist es, ein Verfahren zur Herstellung einer starre und flexible Bereiche aufweisenden Leiterplatte anzugeben, wobei die Leiterbahnen auch auf der Innenseite der starren Einzellage vorhanden sind und wobei flexible Isolationsfolien nur in den flexiblen Bereichen eingesetzt werden müssen, jedoch ohne Zuhilfenahme von starr-flexiblen Vorlaminaten. Ferner soll auf die Verwendung von Druckausgleichspolster verzichtet werden können und dennoch beim Verpressen keine Reliefbildung auf der Kupferfolie auftreten.

Diese Aufgabe wird durch die Art und Reihenfolge der folgenden Verfahrensschritte gelöst: In einer starren Einzellage werden zunächst, z.B. durch Nuten oder Stanzen, Sollbruchstellen entlang der Trennungslinie zwischen dem starren und flexiblen Bereich der Leiterplatte hergestellt. Die Einzellage besteht zweckmäßig aus glasfaserverstärktem Epoxidharz und besitzt auf der Außenseite eine Kupferkaschierung und auf der Gegenfläche bereits eine Schaltungslage, die z.B. mittels konventioneller Ätztechnik hergestellt wurde.

Nach dem Ausbilden der Sollbruchstellen auf der starren Einzellage des flexibel zu gestalteten Bereichs wird eine Isolationsfolie, vorzugsweise aus Polyimid, mittels einer nicht fließenden Kleberschicht auf die starre Einzellage schaltungsseitig aufgebracht. Die Kleberschicht befindet sich nur im Verklebungsbereich zwischen der Isolationsfolie und der starren Einzellage. Sie kann z.B. aus einem Klebeband bestehen, das entweder auf die Isolationsfolie oder auf die starre Einzellage vorpositioniert wird. Die Isolationsfolie überragt die Abmessungen des flexiblen Bereichs allseitig um 3 bis 5 mm, um der Verklebung zwischen Folie und starrer Einzellage genügende Haftkraft zu verleihen. Die Isolationsfolie wird auf ihrer der Einzellage abgewandten Seite mit einer zusätzlichen Kleberschicht versehen, die auch im ausgehärteten Zustand flexibel bleibt.

Anschließend wird ein Prepreg mit gleicher Harzzusammensetzung wie die starre Einzellage, diese überdeckend, aufgelegt, wobei das Prepreg eine Aussparung von der Größe und Lage der flexiblen Isolationsfolie besitzt und gleich oder wenige Mikrometer dicker ist als die Isolationsfolie einschließlich deren Kleberbeschichtungen.

Schließlich wird über das gesamte Prepreg eine durchgehende Kupferfolie gelegt.

Der Verbund wird dann unter Druck und einer Temperatur, die ausreicht, die Kleberschichten aktiv werden zu lassen, zu einem Laminat verpreßt, wobei das Prepreg am Anfang des Preßzyklus niedrigviskos wird und die Isolationsfolie luftfrei umschließt sowie die Leiter auf der starren Einzellage einbettet. Im weiteren Verlauf härtet die Kleberschicht aus und verklebt alle Materialschichten miteinander. Der kurzzeitige Kleberfluß bewirkt gleichzeitig einen Druckausgleich, so daß auf zusätzliche Druckausgleichspolster beim Pressen verzichtet werden kann und man ein planes Laminat mit glatten Kupferoberflächen erhält. Es kann mit bekannten Durchkontaktierungs- und Strukturierverfahren weiter bearbeitet werden.

Ist die Kontur der starr-flexiblen Leiterplatte hergestellt, dann läßt sich im flexiblen Bereich das verbliebene Teilstück der starren Einzellage entlang der Sollbruchstellen leicht entfernen.

Das Prepreg mit einem latent reaktiven Reaktionsharz dient als Isolationsschicht zwischen der Innenlage der starren Einzellage und der Außenlage der Isolationsfolie und gleichzeitig als Niveauausgleich zur Isolationsfolie.

Da die Isolationsfolie beidseitig mit Kleber beschichtet ist, braucht die Kupferfolie keinen eigenen Kleber aufzuweisen; sie wird im starren Bereich durch das Prepreg-Harz und im flexiblen Bereich durch den Kleber auf der Isolationsfolie fest haftend verklebt.

Die folgenden Figuren verdeutlichen das erfindungsgemäße Verfahren. Es zeigen:

Figur 1 die Isolationsfolie mit Klebestreifen;

Figur 2 bis 5 die Herstellung des Leiterplattenverbundes.

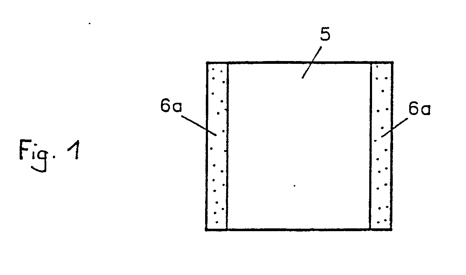

Figur 1 zeigt eine Polyimidfolie 5, auf die nur in den Bereichen Klebestreifen 6a aus nicht fließendem Werkstoff aufgebracht sind, die mit dem Epoxidglashartgewebe 1 verklebt werden sollen.

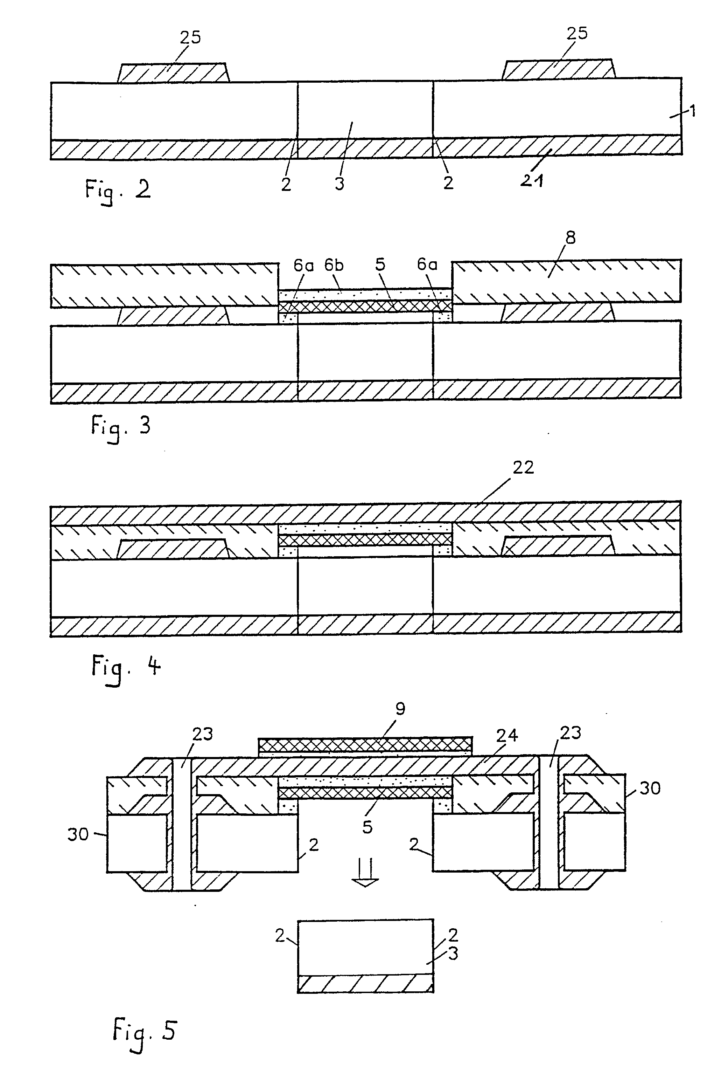

Die starre Einzellage 1 mit vorgefertigten Sollbruchstellen 2 besitzt auf der Innenseite Leiterbahnen 25 (Fig. 2). Gemäß Fig. 3 wird ein Prepreg 8 auf die starre Einzellage 1 gelegt, welches eine Aussparung in der Lage und Größe der Isolationsfolie 5 besitzt.

Die Isolationsfolie 5, die auf der Seite zur starren Einzellage in den Verklebungsbereichen Klebebänder 6a trägt, weist auf ihrer Gegenfläche eine Schicht 6b aus einem Klebstoff auf, der auch nach dem Verkleben flexibel bleibt. Das Prepreg 8 ist gleich dick oder wenige Mikrometer dicker als die Polyimidfolie 5 einschließlich der Beschichtung 6a, 6b, woraus sich nach dem Auflegen der Kupferfolie 22 durch das Fließverhalten des Prepregs 8 eine Planlage der Kupferfolie 22 ergibt (Figuren 3 und 4) und die Leiterbahnen 25 vollständig luftfrei eingebettet werden.

Die Herstellung der Durchkontaktierungen 23 und der Leiterbahnen 24 auf den Außenlagen erfolgt nach dem bekannten Verfahren für starre Vielschicht-Leiterplatten. Zur Erhöhung der mechanischen Festigkeit oder zur Isolation kann eine Deckfolie 9, die ebenfalls im wesentlichen nur den flexiblen Teil überdeckt, auflaminiert werden.

Nach der Bearbeitung der Kontur 30 und dem Entfernen des Teils 3 erhält man die in Figur 5 im Querschnitt dargestellte starr-flexible Mehrlagenschaltung.

Bezugszeichenliste

| 1 | starre Einzellage |
|---|---|
| 2 | Sollbruchstellen in der starren Einzellage |
| 3 | Teilstück der starren Einzellage |
| 5 | Isolierfolien-Stück |
| 6a | Klebestreifen zwischen Isolationsfolie und starrer Einzellage |
| 6b | flexible Klebeschicht zwischen Isolationsfolie und Kupferfolie |
| 8 | Prepreg |
| 9 | Deckfolie |
| 21 | Kupferfolie, kaschiert auf der starren Einzellage 1 |
| 22 | Kupferfolie über dem Prepreg 8 und der Kleberschicht 6b |
| 23 | Durchkontaktierte Bohrungen |
| 24 | Leiterbild auf der Isolationsfolienseite des Verbundes |
| 25 | Leiterbild auf der Innenseite der starren Einzellage |

**Patentansprüche**

Verfahren zur Herstellung einer starre und flexible Bereiche aufweisenden Leiterplatte durch Verpressen von starren und flexiblen Einzellagen und Entfernen der starren Außenlage in den flexibel gewünschten Bereichen, wobei zur Entfernung der starren Außenlage in diesen Bereichen, entlang der Trennlinie zwischen starren und flexiblen Teilen der Leiterplatte, vor dem Verpressen, nach Ausbildung der Leiterbilder, Sollbruchstellen hergestellt und die Bereiche zwischen diesen herausgebrochen werden,

dadurch gekennzeichnet,

daß man nach dem Ausbilden der Sollbruchstellen (2) auf der starren, auf einer Fläche mit einer Kupferschicht (21) kaschierten, auf der Gegenfläche mit einer Schaltungslage (25) versehenen Einzellage (1), innerhalb des flexibel zu gestaltenden Bereichs (3), eine Isolationsfolie (5) mittels einer nicht fließenden Kleberschicht (6a), die sich nur im Verklebungsbereich zwischen Folie (5) und starrem Träger (1) befindet, auf die starre Einzellage (1) schaltungsseitig und nur im flexibel zu gestaltenden Bereich (3) aufklebt, wobei die Isolationsfolie (5) allseitig um 3 bis 5 mm die Abmessungen des flexiblen Bereichs (3) überragt, daß man die Isolationsfolie mit einer zusätzlichen Kleberschicht (6b) auf ihrer der Einzellage (1) abgewandten Seite versieht,

daß man ein Prepreg (8), das gleich dick wie oder wenige Mikrometer dicker ist als die Isolationsfolie (5) einschließlich der Kleberbeschichtung (6a, 6b), und das die gleiche Harzzusammensetzung wie die starre Einzellage (1) aufweist, auf diese überdeckkend aufträgt, wobei das Prepreg (8) im flexiblen Bereich (3) ausgespart ist,

daß man dann über das gesamte Prepreg (8) eine durchgehende Kupferfolie (22) auflegt,

daß man den Verbund unter Druck und bei einer Temperatur, die den Kleber und das Prepreg klebend aktiviert, zu einem Laminat verpreßt, die Kleberverbindungen aushärten läßt und daß man nach der Herstellung der Leiterbilder (23, 24) und der Bearbeitung der Konturen (30) zuletzt im flexiblen Bereich (3) die Einzellage (1) mit der Kupferbeschichtung (21) entlang der Sollbruchstellen (2) entfernt.

Fig. 1

Fig. 2

Fig. 3

Fig. 4

Fig. 5